# EUROPEAN PATENT APPLICATION

(11) **EP 4 657 421 A1**
(43) Date of publication of application: **03.12.2025**
(21) Application number: 24884227.0
(22) Date of filing: 03.09.2024
(51) Int. Cl.: G09G 3/32

(54) **DISPLAY SUBSTRATE AND DRIVING METHOD THEREFOR, AND DISPLAY DEVICE**

(30) Priority: 30.10.2023 CN 202311422427
(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: GUO, Yonglin, Beijing 100176 (CN); SONG, Gukhwan, Beijing 100176 (CN); JIANG, Zhiliang, Beijing 100176 (CN); HU, Ming, Beijing 100176 (CN); LIU, Cong, Beijing 100176 (CN)
(74) Representative: Isarpatent
(86) International application number: PCT/CN2024/116430
(87) International publication number: WO 2025/092220

(57) **Abstract**

A display substrate, a driving method and a display device are provided. The display substrate includes a base substrate, and a first level signal line and a shift register unit on the base substrate. The shift register unit includes a first output transistor, a gate driving signal output end and a first output control node. A gate electrode of the first output transistor is coupled to the first output control node, a first electrode thereof is coupled to the first level signal line, and a second electrode thereof is coupled to the gate driving signal output end. A first capacitor is formed between the first output control node and the gate driving signal output end, a second capacitor is formed between the first output control node and the first level signal line, and the first capacitor has a capacitance greater than or equal to the second capacitor.

## Description

### CROSS-REFERENCE TO RELATED APPLICATION

This application claims a priority of the Chinese patent application No. 202311422427.6 filed on October 30, 2023, which is incorporated herein by reference in its entirety.

### TECHNICAL FIELD

The present disclosure relates to the field of display technology, in particular to a display substrate, a driving method and a display device.

### BACKGROUND

Currently, an Active-Matrix Organic Light-Emitting Diode (AMOLED) flexible screen is more and more mature, and it becomes a next-generation display mode for replacing a Liquid Crystal Display (LCD) due to such characteristics as being flexible, high contrast and low power consumption.

Along with the continuous development of the OLED technology, many gate driving circuits for new functions have been presented, and these gate driving circuits are integrated into an array substrate, so as to provide a display product with a narrow bezel. However, in a case that the display product is driven by the current gate driving circuit, display quality of the display product is relatively bad.

### SUMMARY

An object of the present disclosure is to provide a display substrate, a driving method and a display device, so as to solve the above-mentioned problem.

In order to achieve the above-mentioned object, the present disclosure provides the following technical solutions.

In one aspect, the present disclosure provides in some embodiments a display substrate, including a base substrate, and a first level signal line and a shift register unit on the base substrate. The shift register unit includes a first output transistor, a gate driving signal output end and a first output control node; a gate electrode of the first output transistor is coupled to the first output control node, a first electrode of the first output transistor is coupled to the first level signal line, and a second electrode of the first output transistor is coupled to the gate driving signal output end; and a first capacitor is formed between the first output control node and the gate driving signal output end, a second capacitor is formed between the first output control node and the first level signal line, and the first capacitor has a capacitance greater than or equal to the second capacitor.

In a possible embodiment of the present disclosure, the gate electrode of the first output transistor includes at least one gate electrode pattern extending in a first direction, the first electrode of the first output transistor includes at least one first electrode pattern extending in the first direction, and the second electrode of the first output transistor includes at least one second electrode pattern extending in the first direction; the first electrode pattern and the second electrode pattern are arranged in a second direction intersecting the first direction, and an orthogonal projection of the gate electrode pattern onto the base substrate is arranged between an orthogonal projection of an adjacent first electrode pattern onto the base substrate and an orthogonal projection of the second electrode pattern onto the base substrate; and the orthogonal projection of at least one of the gate electrode patterns onto the base substrate is spaced apart from the orthogonal projection of the adjacent first electrode pattern onto the base substrate by a first distance, the orthogonal projection of at least one of the gate electrode patterns onto the base substrate is spaced apart from the orthogonal projection of an adjacent second electrode pattern onto the base substrate by a second distance, and the first distance is greater than the second distance.

In a possible embodiment of the present disclosure, the gate electrode of the first output transistor includes a gate electrode connection member and at least two gate electrode patterns coupled to the gate electrode connection member, the first electrode of the first output transistor includes a first electrode connection member and at least two first electrode patterns coupled to the first electrode connection member, the second electrode of the first output transistor includes a second electrode connection member and at least two second electrode patterns coupled to the second electrode connection member, the first electrode patterns and the second electrode patterns are arranged alternately in the second direction, the first electrode connection member is coupled to the first level signal line, and the second electrode connection member is coupled to the gate driving signal output end.

In a possible embodiment of the present disclosure, the orthogonal projection of each gate electrode pattern onto the base substrate is spaced apart from the orthogonal projection of the adjacent first electrode pattern onto the base substrate by the first distance, and the orthogonal projection of each gate electrode pattern onto the base substrate is spaced apart from the orthogonal projection of the adjacent second electrode pattern onto the base substrate by the second distance.

In a possible embodiment of the present disclosure, the orthogonal projection of at least one gate electrode pattern onto the base substrate at least partially overlaps with an orthogonal projection of the second electrode connection member onto the base substrate.

In a possible embodiment of the present disclosure, the shift register unit further includes an output end connection member coupled to the gate driving signal output end and the second electrode of the first output transistor, and an orthogonal projection of the output end connection member onto the base substrate does not overlap with the orthogonal projection of the gate electrode pattern onto the base substrate.

In a possible embodiment of the present disclosure, the shift register unit further includes an output end extension member coupled to the output end connection member, and an orthogonal projection of the output end extension member onto the base substrate at least partially overlaps with the orthogonal projection of the gate electrode pattern onto the base substrate.

In a possible embodiment of the present disclosure, the orthogonal projection of the output end extension member onto the base substrate at least partially overlaps with the orthogonal projection of the second electrode connection member onto the base substrate.

In a possible embodiment of the present disclosure, the display substrate includes a first gate metal layer, a second gate metal layer and a first source/drain metal layer laminated one on another in a direction away from the base substrate, the gate electrode of the first output transistor is arranged at a same layer, and made of a same material, as the first gate metal layer, the first electrode and the second electrode of the first output transistor are arranged at a same layer, and made of a same material, as the first source/drain metal layer, and the output end connection member and the output end extension member are arranged at a same layer, and made of a same material, as the second gate metal layer.

In a possible embodiment of the present disclosure, the first output transistor further includes a first output active layer, the shift register unit further includes a first compensation pattern coupled to the gate electrode of the first output transistor, an orthogonal projection of the first compensation pattern onto the base substrate does not overlap with an orthogonal projection of the first output active layer onto the base substrate, and the orthogonal projection of the first compensation pattern onto the base substrate at least partially overlaps with the orthogonal projection of the output end extension member onto the base substrate.

In a possible embodiment of the present disclosure, the output end extension member includes a first extension portion and a second extension portion coupled to each other, the first extension portion extends in the first direction, the second extension portion extends in the second direction, an orthogonal projection of the first extension portion onto the base substrate at least partially overlaps with the orthogonal projection of the first compensation pattern onto the base substrate, an orthogonal projection of the second extension portion onto the base substrate at least partially overlaps with the orthogonal projection of the second electrode connection member onto the base substrate, and the first compensation pattern and the gate electrode pattern are arranged in the second direction.

In a possible embodiment of the present disclosure, the first output transistor further includes a first output active layer, the first output active layer has a first length in the first direction, the gate electrode pattern has a second length in the first direction, and the first length is smaller than or equal to two thirds of the second length.

In a possible embodiment of the present disclosure, the second electrode pattern has a third length in the first direction, and the first length is smaller than or equal to two thirds of the third length.

In a possible embodiment of the present disclosure, the first electrode pattern has a fourth length in the first direction, the fourth length is smaller than the third length, and/or the fourth length is smaller than the second length.

In a possible embodiment of the present disclosure, the shift register unit further includes a compensation capacitor, the compensation capacitor includes a first compensation plate and a second compensation plate, the first compensation plate is coupled to the gate electrode of the first output transistor, the second compensation plate is coupled to the second electrode of the first output transistor, and an orthogonal projection of the first compensation plate onto the base substrate at least partially overlaps with an orthogonal projection of the second compensation plate onto the base substrate.

In a possible embodiment of the present disclosure, the first compensation plate is coupled to two adjacent gate electrode patterns, and the second compensation plate is coupled to the second electrode connection member and two adjacent second electrode patterns.

In a possible embodiment of the present disclosure, the first compensation plate and the gate electrode pattern form an integral structure, and the second compensation plate, the second electrode connection member and the second electrode pattern form an integral structure.

In a possible embodiment of the present disclosure, the first output transistor further includes a first output active layer; at least a portion of an orthogonal projection of the first output active layer onto the base substrate and the orthogonal projection of the first compensation plate onto the base substrate are arranged in the first direction, and at least a portion of the orthogonal projection of the first output active layer onto the base substrate and at least a portion of the orthogonal projection of the first compensation plate onto the base substrate are arranged in the second direction; and/or at least a portion of the orthogonal projection of the first output active layer onto the base substrate and the orthogonal projection of the second compensation plate onto the base substrate are arranged in the first direction, and at least a portion of the orthogonal projection of the first output active layer onto the base substrate and at least a portion of the orthogonal projection of the second compensation plate onto the base substrate are arranged in the second direction.

In a possible embodiment of the present disclosure, the display substrate further includes a second level signal line, the shift register unit further includes a second output transistor and a second output control node, a gate electrode of the second output transistor is coupled to the second output control node, a first electrode of the second output transistor is coupled to the second level signal line, and a second electrode of the second output transistor is coupled to the gate driving signal output end.

In another aspect, the present disclosure provides in some embodiments a display device including the above-mentioned display substrate.

In yet another aspect, the present disclosure provides in some embodiments a driving method for the above-mentioned display substrate. The display substrate includes a base substrate, and a first level signal line and a shift register unit on the base substrate, wherein the shift register unit includes a first output transistor, a gate driving signal output end and a first output control node; a gate electrode of the first output transistor is coupled to the first output control node, a first electrode of the first output transistor is coupled to the first level signal line, and a second electrode of the first output transistor is coupled to the gate driving signal output end; and a first capacitor is formed between the first output control node and the gate driving signal output end, a second capacitor is formed between the first output control node and the first level signal line, and the first capacitor has a capacitance greater than or equal to the second capacitor. The driving method includes controlling, by the first output control node, the first output transistor to be turned on or off.

In a possible embodiment of the present disclosure, the display substrate includes a frame start signal line, a first clock signal line, a third level signal line, and a plurality of cascaded shift register units, each shift register unit further includes a first input transistor, a second input transistor, a first transmission transistor, a second transmission transistor and a control transistor; a gate electrode of the first input transistor is coupled to a corresponding first clock signal line, a second electrode of the first input transistor is coupled to a first electrode of the first transmission transistor, a gate electrode of the first transmission transistor is coupled to the third level signal line, a second electrode of the first transmission transistor is coupled to the first output control node, a gate electrode of the second input transistor is coupled to a corresponding first clock signal line, a second electrode of the second input transistor is coupled to a first electrode of the second transmission transistor, a gate electrode of the second transmission transistor is coupled to the third level signal line, a second electrode of the second transmission transistor is coupled to a gate electrode and a second electrode of the control transistor, and a first electrode of the control transistor is coupled to the first output control node; in a first shift register unit, the first electrode of the first input transistor is coupled to the frame start signal line, and in an n^{th} shift register unit, the first electrode of the first input transistor is coupled to a gate driving signal output end of an (n-1)^{th} shift register unit, where n is an integer greater than or equal to 2; a low level of a first clock signal transmitted by the first clock signal line is smaller than a level of a first level signal transmitted by the first level signal line; and/or the low level of the first clock signal transmitted by the first clock signal line is smaller than a level of a frame start signal; and/or a level of a third level signal transmitted by the third level signal line is smaller than the level of the first level signal transmitted by the first level signal line.

### BRIEF DESCRIPTION OF THE DRAWINGS

The following drawings are provided to facilitate the understanding of the present disclosure, and constitute a portion of the description. These drawings and the following embodiments are for illustrative purposes only, but shall not be construed as limiting the present disclosure. In these drawings,
Fig. 1 is a first circuit diagram of a shift register unit according to one embodiment of the present disclosure;
Fig. 2 is a schematic view showing a relationship between a step of a gate driving signal and C_N7_out according to one embodiment of the present disclosure;
Fig. 3 is a schematic view showing a relationship between the step of a gate driving signal and C_N7_VGL according to one embodiment of the present disclosure;
Fig. 4 is a sectional view of film layers of a display substrate according to one embodiment of the present disclosure;
Fig. 5 is a schematic view showing the layout of an active layer in the shift register unit according to one embodiment of the present disclosure;
Fig. 6 is a schematic view showing the layout of a first gate metal layer in the shift register unit according to one embodiment of the present disclosure;
Fig. 7 is a schematic view showing the layout of a second gate metal layer in the shift register unit according to one embodiment of the present disclosure;
Fig. 8 is a schematic view showing the layout of a first source/drain metal layer in the shift register unit according to one embodiment of the present disclosure;
Fig. 9 is a schematic view showing the layout of a second source/drain metal layer in the shift register unit according to one embodiment of the present disclosure;
Fig. 10 is a schematic view showing the layout of the active layer and the first gate metal layer in the shift register unit according to one embodiment of the present disclosure;
Fig. 11 is a schematic view showing the layout of the shift register unit in Fig. 10 added with the second gate metal layer;
Fig. 12 is a schematic view showing the layout of the shift register unit in Fig. 11 added with the first source/drain metal layer;
Fig. 13 is a schematic view showing the layout of the shift register unit in Fig. 13 added with the second source/drain metal layer;
Fig. 14 is a schematic view showing the layout of the shift register unit in Fig. 13 added with the first source/drain metal layer and the second source/drain metal layer;
Fig. 15 is a schematic view showing the layout of the first gate metal layer and the first source/drain metal layer in the shift register unit according to one embodiment of the present disclosure;
Fig. 16 is a schematic view showing the layout of the shift register unit in Fig. 15 added with the second gate metal layer;
Fig. 17 is a schematic view showing the layout of the shift register unit in Fig. 16 added with the active layer and the second source/drain metal layer;
Fig. 18 is a schematic view showing the layout of the first gate metal layer, the second gate metal layer and the first source/drain metal layer in the shift register unit according to one embodiment of the present disclosure;
Fig. 19 is a schematic view showing the layout of the shift register unit in Fig. 18 added with the active layer and the second source/drain metal layer;
Fig. 20 is another schematic view showing the layout of the active layer in the shift register unit according to one embodiment of the present disclosure;
Fig. 21 is a schematic view showing the layout of the first gate metal layer, the second gate metal layer and the first source/drain metal layer in the shift register unit according to one embodiment of the present disclosure;
Fig. 22 is a schematic view showing the layout of the shift register unit in Fig. 21 added with the active layer;
Fig. 23 is yet another schematic view showing the layout of the active layer in the shift register unit according to one embodiment of the present disclosure;
Fig. 24 is a schematic view showing the layout of the first gate metal layer, the second gate metal layer and the first source/drain metal layer in the shift register unit according to one embodiment of the present disclosure;
Fig. 25 is a schematic view showing the layout of the shift register unit in Fig. 24 added with the active layer;
Fig. 26 is a schematic view showing the layout of the shift register unit in Fig. 25 added with the second source/drain metal layer;
Fig. 27 is still yet another schematic view showing the layout of the active layer in the shift register unit according to one embodiment of the present disclosure;
Fig. 28 is a schematic view showing the layout of the first gate metal layer, the second gate metal layer and the first source/drain metal layer in the shift register unit according to one embodiment of the present disclosure;
Fig. 29 is a schematic view showing the layout of the shift register unit in Fig. 28 added with the active layer;
Fig. 30 is a schematic view showing the layout of the shift register unit in Fig. 29 added with the second source/drain metal layer;
Fig. 31 is a schematic view showing the layout of the shift register unit in Fig. 21 added with the first gate metal layer;
Fig. 32 is a schematic view showing the layout of the shift register unit in Fig. 21 added with the second gate metal layer; and
Fig. 33 is a circuit diagram of the shift register unit according to one embodiment of the present disclosure.

### DETAILED DESCRIPTION

The present disclosure will be described hereinafter in details in conjunction with the drawings and embodiments.

In a display product, a gate driving circuit includes a plurality of cascaded shift register units, a gate driving signal output end of each shift register unit is coupled to a corresponding scanning line, and the scanning line is coupled to corresponding subpixels in a display region and configured to transmit the gate driving signal from the gate driving signal output end to the corresponding subpixels, so as to drive the subpixels.

In the related art, there is a step for the gate driving signal outputted by the shift register unit, so the gate driving signal has insufficient output stability. In a case that the display product is driven by the gate driving signal to display, it is impossible to provide high display quality.

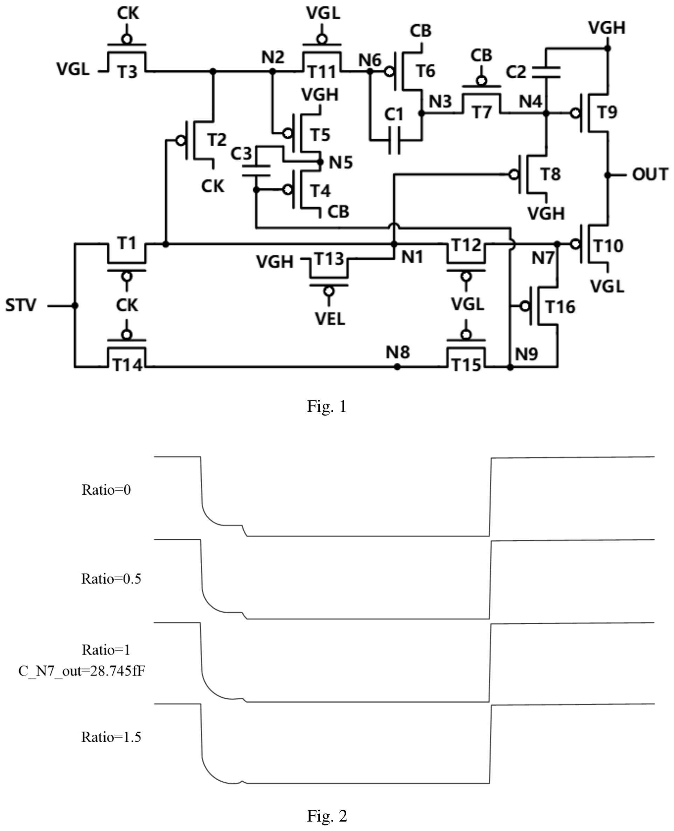

As shown in Fig. 1, the present disclosure provides in some embodiments a shift register unit of a 16T3C (i.e., 16 transistors and 3 capacitors) circuit structure. The shift register unit includes a first transistor T1, a second transistor T2, a third transistor T3, a fourth transistor T4, a fifth transistor T5, a sixth transistor T6, a seventh transistor T7, an eighth transistor T8, a ninth transistor T9, a tenth transistor T10, an eleventh transistor T11, a twelfth transistor T12, a thirteenth transistor T13, a fourteenth transistor T14, a fifteenth transistor T15, a sixteenth transistor T16, a first capacitor unit C1, a second capacitor unit C2, and a third capacitor unit C3.

A gate electrode of the first transistor T1 is coupled to a first clock signal line CK, a first electrode of the first transistor T1 is coupled to a frame start signal line STV, and a second electrode of the first transistor T1 is coupled to a first node N1.

A gate electrode of the second transistor T2 is coupled to the first node N1, a first electrode of the second transistor T2 is coupled to the first clock signal line CK, and a second electrode of the second transistor T2 is coupled to a second node N2.

A gate electrode of the third transistor T3 is coupled to the first clock signal line CK, a first electrode of the third transistor T3 is coupled to a first level signal line VGL, and a second electrode of the third transistor T3 is coupled to the second node N2.

A gate electrode of the fourth transistor T4 is coupled to a ninth transistor N9, a first electrode of the fourth transistor T4 is coupled to a second clock signal line CB, and a second electrode of the fourth transistor T4 is coupled to a ninth node N5.

A gate electrode of the fifth transistor T5 is coupled to the second node N2, a first electrode of the fifth transistor T5 is coupled to a second level signal line VGH, and a second electrode of the fifth transistor T5 is coupled to the fifth node N5.

A gate electrode of the sixth transistor T6 is coupled to a sixth node N6, a first electrode of the sixth transistor T6 is coupled to the second clock signal line CB, and a second electrode of the sixth transistor T6 is coupled to a third node N3.

A gate electrode of the seventh transistor T7 is coupled to the second clock signal line CB, a first electrode of the seventh transistor T7 is coupled to the third node N3, and a second electrode of the seventh transistor T7 is coupled to a fourth node N4.

A gate electrode of the eighth transistor T8 is coupled to the first node N1, a first electrode of the eighth transistor T8 is coupled to the second level signal line VGH, and a second electrode of the eighth transistor T8 is coupled to the fourth node N4.

A gate electrode of the ninth transistor T9 is coupled to the fourth node N4, a first electrode of the ninth transistor T9 is coupled to the second level signal line VGH, and a second electrode of the ninth transistor T9 is coupled to a gate driving signal output end OUT.

A gate electrode of the tenth transistor T10 is coupled to a seventh node N7, a first electrode of the tenth transistor T10 is coupled to the first level signal line VGL, and a second electrode of the tenth transistor T10 is coupled to the gate driving signal output end OUT.

A gate electrode of the eleventh transistor T11 is coupled to the first level signal line VGL, a first electrode of the eleventh transistor T11 is coupled to the second node N2, and a second electrode of the eleventh transistor T11 is coupled to a sixth node N6.

A gate electrode of the twelfth transistor T12 is coupled to the first level signal line VGL, a first electrode of the twelfth transistor T12 is coupled to the first node N1, and a second electrode of the twelfth transistor T12 is coupled to a seventh node N7.

A gate electrode of the thirteenth transistor T13 is coupled to a power source line VEL, a first electrode of the thirteenth transistor T13 is coupled to the second level signal line VGH, and a second electrode of the thirteenth transistor T13 is coupled to the first node N1.

A gate electrode of the fourteenth transistor T14 is coupled to the first clock signal line CK, a first electrode of the fourteenth transistor T14 is coupled to the frame start signal line STV, and a second electrode of the fourteenth transistor T14 is coupled to an eighth node N8.

A gate electrode of the fifteenth transistor T15 is coupled to the first level signal line VGL, a first electrode of the fifteenth transistor T15 is coupled to the eighth node N8, and a second electrode of the fifteenth transistor T15 is coupled to a ninth node N9.

A gate electrode of the sixteenth transistor T16 is coupled to the ninth node N9, a first electrode of the sixteenth transistor T16 is coupled to the seventh node N7, and a second electrode of the sixteenth transistor T16 is coupled to the ninth node N9.

A first plate C11 of the first capacitor unit C1 is coupled to the sixth node N6, and a second plate C12 of the first capacitor unit C1 is coupled to the third node N3. A first plate C21 of the second capacitor unit C2 is coupled to the fourth node N4, and a second plate C22 of the second capacitor unit C2 is coupled to the second level signal line VGH.

A first plate C32 of the third capacitor unit C3 is coupled to the fifth node N5, and a second plate C31 of the third capacitor unit C3 is coupled to the ninth node N9.

Through the shift register unit with the above-mentioned structure, it is able to prevent the occurrence of a step for the output signal and improve the stability of the output signal, thereby to increase display quality of a display product. However, in actual use, there is still the step in a case that a layout design of the shift register unit is inappropriate.

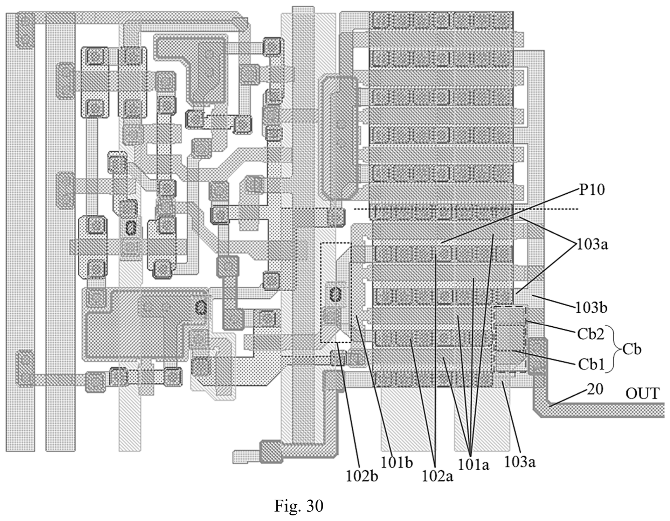

As shown in Figs. 1, 5 and 30, the present disclosure provides in some embodiments a display substrate, which includes a base substrate, and a first level signal line VGL and a shift register unit on the base substrate.

The shift register unit includes a first output transistor (e.g., the tenth transistor T10), a gate driving signal output end OUT and a first output control node (e.g., the seventh node N7). A gate electrode 101 of the first output is coupled to the first output control node, a first electrode 102 of the first output transistor is coupled to the first level signal line VGL, and a second electrode 103 of the first output transistor is coupled to the gate driving signal output end OUT. A first capacitor is formed between the first output control node and the gate driving signal output end OUT, a second capacitor is formed between the first output control node and the first level signal line VGL, and the first capacitor has a capacitance greater than or equal to the second capacitor.

For example, the display substrate includes a display region and a peripheral region surrounding the display region. The display substrate includes a gate driving circuit, and the gate driving circuit includes a plurality of cascaded shift register units located in the peripheral region. For example, the shift register unit includes, but not limited to, the above-mentioned 16T3C circuit structure.

For example, the display substrate includes a plurality of subpixels located in the display region, and a plurality of subpixel driving circuits of the plurality of subpixels is arranged in an array form. The plurality of subpixel driving circuits is arranged in rows and columns. The rows of subpixel driving circuits are arranged in a second direction, and each row of subpixel driving circuits includes a plurality of subpixel driving circuits arranged in a first direction. The columns of subpixel driving circuits are arranged in the first direction, and each column of subpixel driving circuits includes a plurality of subpixel driving circuits arranged in the second direction. For example, the first direction intersects the second direction. For example, the first direction includes a horizontal direction, and the second direction includes a longitudinal direction. For example, each subpixel includes a subpixel driving circuit and a light-emitting element, and the subpixel driving circuit is coupled to an anode of the light-emitting element and configured to provide a driving signal to drive the light-emitting element to emit light.

For example, the display substrate includes a plurality of scanning lines, and the shift register unit is coupled to a corresponding scanning line. The scanning line is coupled to the subpixel driving circuits in a corresponding row of subpixel driving circuits. Taking a 7T1C (i.e., 7 transistors and 1 capacitor) subpixel driving circuit as an example, the scanning line is coupled to, but not limited to, a gate electrode of a compensation transistor in the subpixel driving circuit.

For example, the first level signal line VGL includes, but not limited to, a low level signal line.

For example, the first electrode 102 of the first output transistor includes a drain electrode, the second electrode 103 of the first output transistor includes a source electrode, but the present disclosure is not limited thereto.

Through simulation, the 16T3C circuit structure differs from an existing 12T3C (i.e., 12 transistors and 3 capacitors) circuit structure in that, in the 16T3C circuit structure, a potential at the first output control node (i.e., the seventh node N7) is pulled down in a bootstrapping manner through the first output transistor (i.e., the tenth transistor T10) and a first level signal transmitted via the first level signal line VGL. Hence, in a case that a capacitor C_N7_out between the first output control node and the gate driving signal output end OUT increases, it is advantageous to the elimination of the step, and in a case that a capacitor C_N7_VGL between the first output control node and the first level signal line VGL increases, it is adverse to the elimination of the step. Usually, the two capacitors are generated by the first output transistor, i.e., C_N7_out corresponds to a gate-to-source capacitor Cgs of the first output transistor, and C_N7_VGL corresponds to a gate-to-drain capacitor Cgd of the first output transistor. Due to the coexistence of Cgs and Cgd, it is not that the bigger the first output transistor, the better it will be.

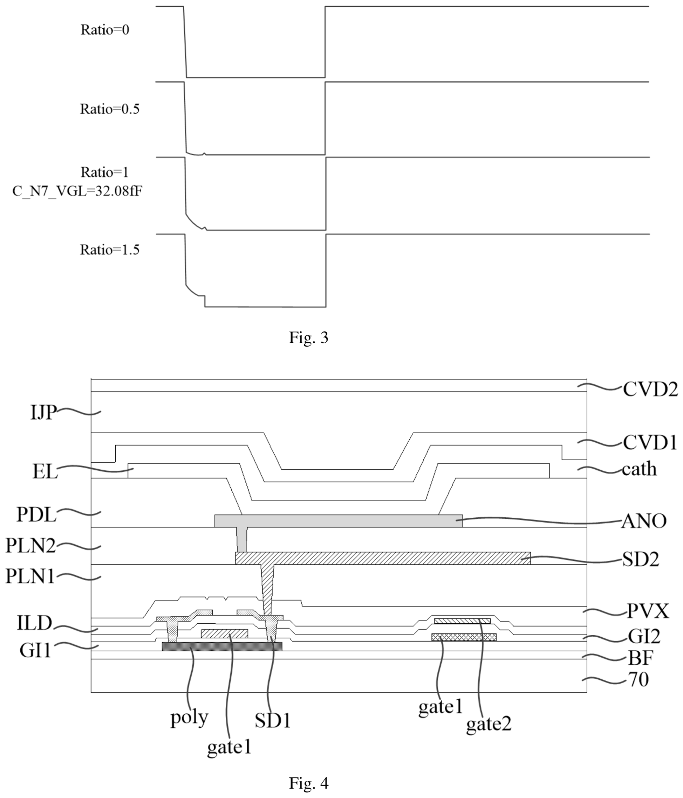

More specifically, as shown in Fig. 2, the first capacitor C_N7_out between the first output control node and the gate driving signal output end OUT increases, so as to reduce the step. As shown in Fig. 3, the second capacitor C_N7_VGL between the first output control node and the first level signal line VGL decreases, so as to reduce the step. In Figs. 2 and 3, "ratio" represents a capacitance setting ratio. In Fig. 2, a basic capacitance of C_N7_out is 28.745fF, and in Fig. 3, a basic capacitance of C_N7_VGL is 32.08fF. A capacitance of each signal line is a product of the basic capacitance and the ratio. The basic capacitance is a reference capacitance used for the simulation, and it may be set according to the practical need, i.e., the basic capacitance is not limited to the values mentioned hereinabove.

Based on the specific structure of the display substrate, in the embodiments of the present disclosure, the first capacitor is formed between the first output control node and the gate driving signal output end OUT, the second capacitor is formed between the first output control node and the first level signal line VGL, and the capacitance of the first capacitor is greater than the capacitance of the second capacitor, so that the first capacitor having a larger capacitance is formed between the first output control node and the gate driving signal output end OUT, and the second capacitor having a smaller capacitance is formed between the first output control node and the first level signal line VGL. As a result, it is able to effectively reduce the step of the gate driving signal outputted by the shift register unit, improve the output stability of the gate driving signal, and prevent the occurrence of such display defects as mura in a case that a display product is driven by the gate driving signal for display, thereby to provide high display quality.

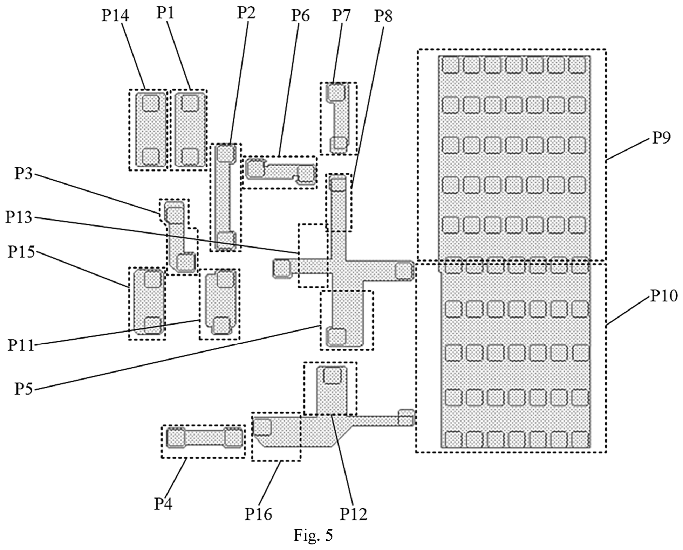

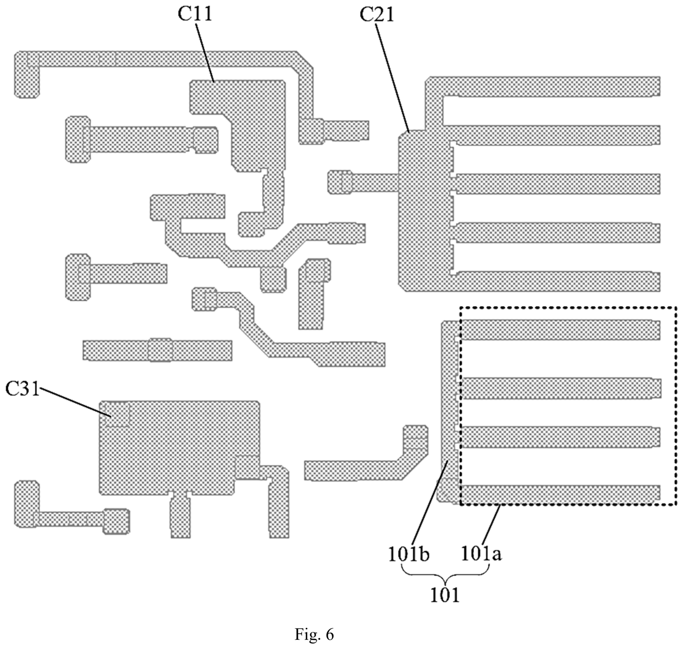

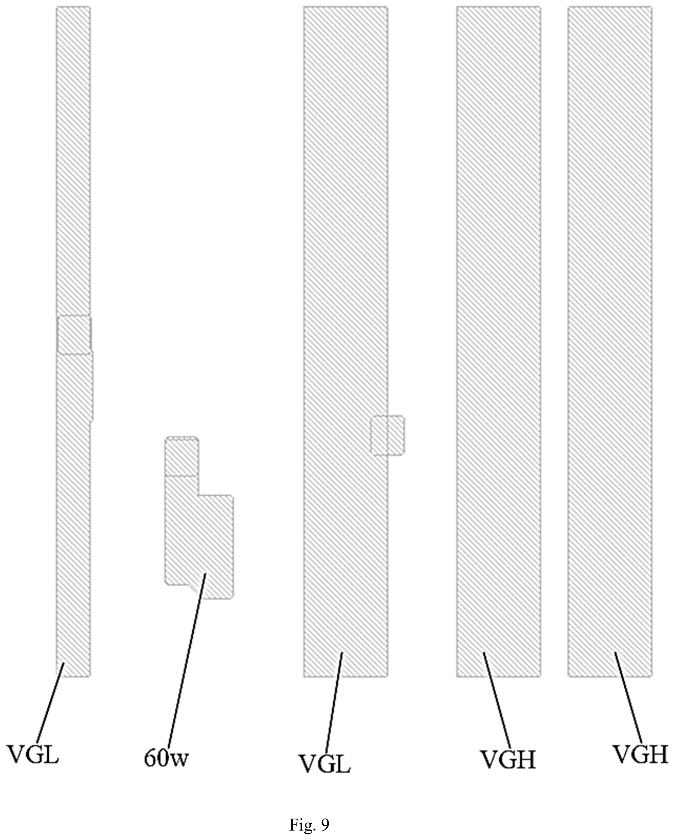

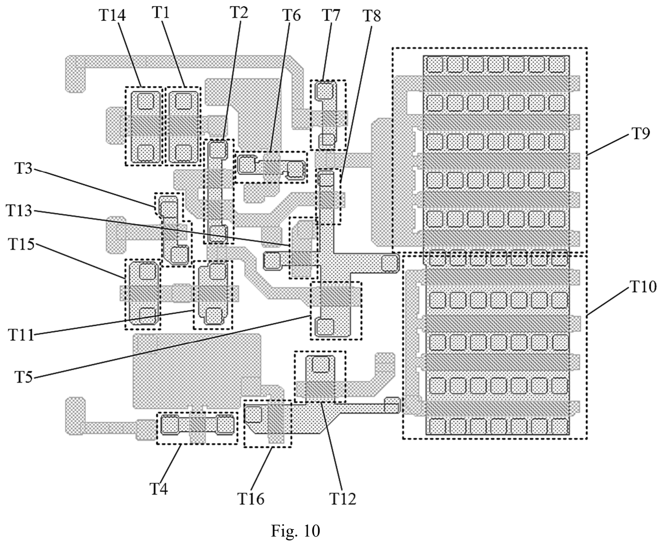

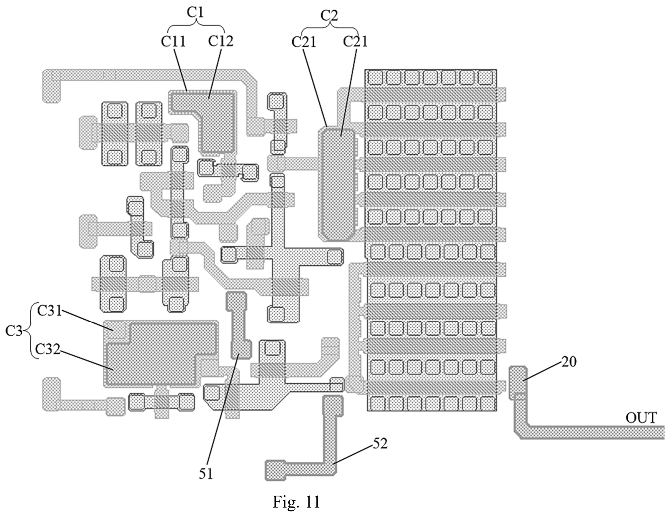

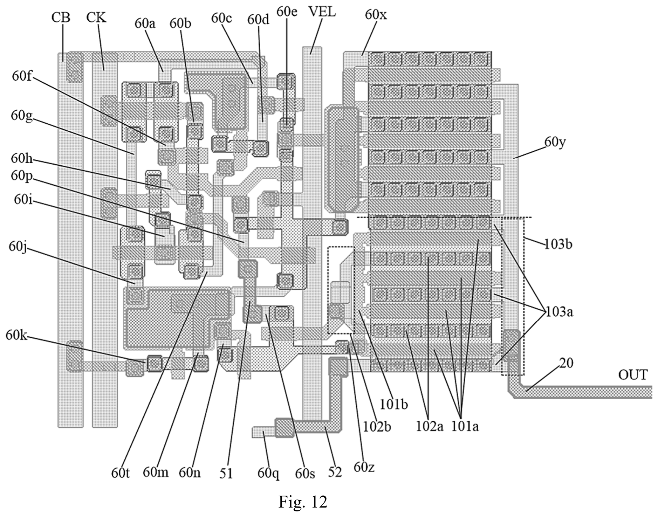

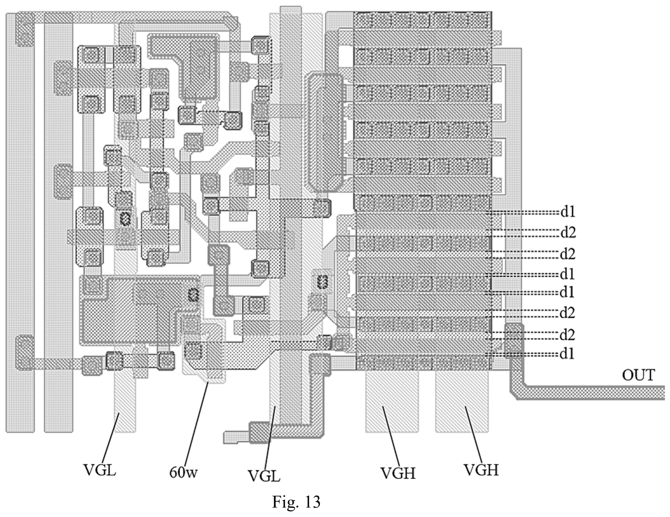

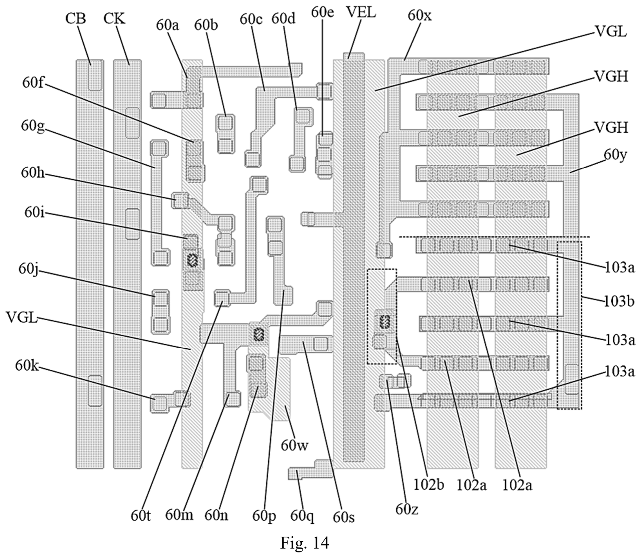

As shown in Figs. 5 to 14, in some embodiments of the present disclosure, the gate electrode 101 of the first output transistor includes at least one gate electrode pattern 101a extending in a first direction, the first electrode 102 of the first output transistor includes at least one first electrode pattern 102a extending in the first direction, and the second electrode 103 of the first output transistor includes at least one second electrode pattern 103a extending in the first direction.

The first electrode pattern 102a and the second electrode pattern 103a are arranged in a second direction intersecting the first direction, and an orthogonal projection of the gate electrode pattern 101a onto the base substrate is arranged between an orthogonal projection of an adjacent first electrode pattern 102a onto the base substrate and an orthogonal projection of the second electrode pattern 103a onto the base substrate.

The orthogonal projection of at least one of the gate electrode patterns 101a onto the base substrate is spaced apart from the orthogonal projection of the adjacent first electrode pattern 102a onto the base substrate by a first distance d2, the orthogonal projection of at least one of the gate electrode patterns 101a onto the base substrate is spaced apart from the orthogonal projection of an adjacent second electrode pattern 103a onto the base substrate by a second distance d1, and the first distance d2 is greater than the second distance d1.

For example, the gate electrode 101 of the first output transistor includes a gate electrode connection member 101b and at least two gate electrode patterns 101a coupled to the gate electrode connection member 101b, the first electrode 102 of the first output transistor includes a first electrode connection member 102b and at least two first electrode patterns 102a coupled to the first electrode connection member 102b, the second electrode 103 of the first output transistor includes a second electrode connection member 103b and at least two second electrode patterns 103a coupled to the second electrode connection member 103b, the first electrode patterns 102a and the second electrode patterns 103a are arranged alternately in the second direction, the first electrode connection member 102b is coupled to the first level signal line VGL, and the second electrode connection member 103b is coupled to the gate driving signal output end OUT.

For example, the gate electrode connection member 101b and the gate electrode pattern 101a coupled thereto form an integral structure, the first electrode connection member 102b and the first electrode pattern 102a coupled thereto form an integral structure, and the second electrode connection member 103b and the second electrode pattern 103a coupled thereto form an integral structure.

For example, the first electrode connection member 102b includes at least a portion extending in the second direction, and the second electrode connection member 103b includes at least a portion extending in the second direction.

For example, the orthogonal projection of each gate electrode pattern 101a onto the base substrate is spaced apart from the orthogonal projection of the adjacent first electrode pattern 102a onto the base substrate by the first distance, and the orthogonal projection of each gate electrode pattern 101a onto the base substrate is spaced apart from the orthogonal projection of the adjacent second electrode pattern 103a onto the base substrate by the second distance.

For example, the first capacitor C_N7_out between the first output control node and the gate driving signal output end OUT includes a capacitor formed between a structure coupled to the gate driving signal output end OUT and also used to transmit the gate driving signal and the first output control node. The second capacitor C_N7_VGL between the first output control node and the first level signal line VGL includes a capacitor formed between a structure coupled to the first level signal line VGL and also used to transmit a first level signal and the first output control node. The gate electrode 101 of the first output transistor may serve as the first output control node.

For example, the first distance includes a distance between the orthogonal projection of the gate electrode pattern 101a onto the base substrate and the orthogonal projection of the adjacent first electrode pattern 102a onto the base substrate in the second direction, and the second distance includes a distance between the orthogonal projection of the gate electrode pattern 101a onto the base substrate and the orthogonal projection of the adjacent second electrode pattern 103a onto the base substrate in the second direction.

For example, the first distance includes a minimum distance between the orthogonal projection of the gate electrode pattern 101a onto the base substrate and the orthogonal projection of the adjacent first electrode pattern 102a onto the base substrate, and the second distance includes a minimum distance between the orthogonal projection of the gate electrode pattern 101a onto the base substrate and the orthogonal projection of the adjacent second electrode pattern 103a onto the base substrate.

For example, the first distance is, but not limited to, within a range of 1.5 µm to 2.5 µm. For example, the first distance is 1.5 µm, 1.7 µm, 1.9 µm, 2.1 µm, 2.3 µm, or 2.5 µm.

For example, the second distance is, but not limited to, within a range of 0.3 µm to 1.1 µm. For example, the second distance is 0.3 µm, 0.5 µm, 0.7 µm, 0.9 µm, or 1.1 µm.

For example, the orthogonal projection of the gate electrode pattern 101a onto the base substrate is spaced apart from the orthogonal projection of the adjacent first electrode pattern 102a onto the base substrate by the first distance, and the first distance is negatively correlated to the capacitance of the gate-to-drain capacitor Cgd of the first output transistor, i.e., the first distance is negatively correlated to the capacitance of the second capacitor C_N7_VGL. The larger the first distance, the smaller the capacitance of the second capacitor C_N7_VGL. For example, the orthogonal projection of the gate electrode pattern 101a onto the base substrate is spaced apart from the orthogonal projection of the adjacent second electrode pattern 103a onto the base substrate by the second distance, and the second distance is negatively correlated to the capacitance of the gate-to-source capacitor Cgs of the first output transistor, i.e., the second distance is negatively correlated to the capacitance of the first capacitor C_N7_out. The smaller the second distance, the larger the capacitance of the first capacitor C_N7_out.

It should be appreciated that, the capacitance of the second capacitor C_N7_VGL includes two parts. A first part is a capacitance of the first output transistor itself, and a size of the first part is associated with a channel length and a channel width of the first output transistor, and an operating state of the transistor. A second part is a surface capacitance or a 3D capacitance generated with the other line, and the second part meets the formula C=εS/4πkd, where ε represents a dielectric constant, S represents an overlapping area between the two plates of the capacitor, d represents a distance between the two plates of the capacitor, and k represents a constant.

In the display substrate provided in the embodiments of the present disclosure, the orthogonal projection of at least one gate electrode pattern 101a onto the base substrate is spaced apart from the orthogonal projection of the adjacent first electrode pattern 102a onto the base substrate by the first distance, the orthogonal projection of at least one gate electrode pattern 101a onto the base substrate is spaced apart from the orthogonal projection of the adjacent second electrode pattern 103a onto the base substrate by the second distance, and the first distance is greater than the second distance. In this way, the gate electrode pattern 101a is arranged closer to the second electrode pattern 103a and further away from the first electrode pattern 102a, so it is able to effectively increase the capacitance of the first capacitor C_N7_out and reduce the capacitance of the second capacitor C_N7_VGL, thereby to reduce the step of the gate driving signal outputted by the shift register unit, and improve the output stability of the gate driving signal.

Hence, in the display substrate provided in the embodiments of the present disclosure, through the appropriate layout of the shift register unit, the capacitance of the first capacitor C_N7_out increases and the capacitance of the second capacitor C_N7_VGL decreases, so it is able to effectively reduce the step of the gate driving signal outputted by the shift register unit, improve the output stability of the gate driving signal, and prevent the occurrence of such display defects as Mura in a case that the display product is driven by the gate driving signal for display, thereby to provide the high display quality.

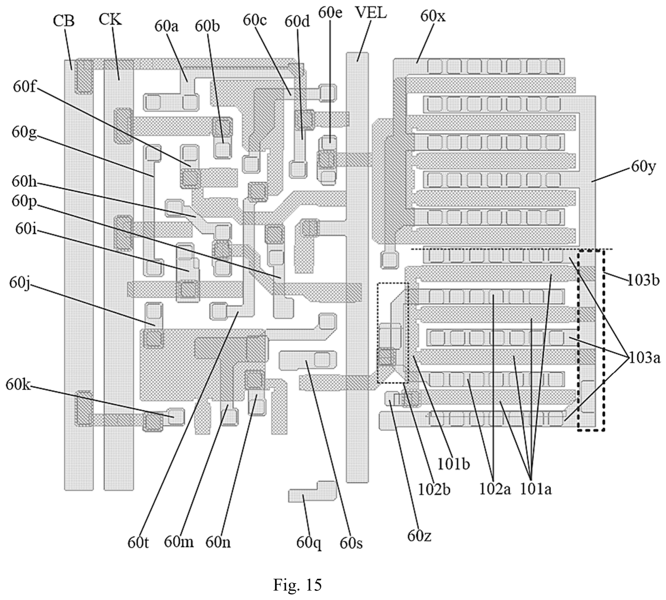

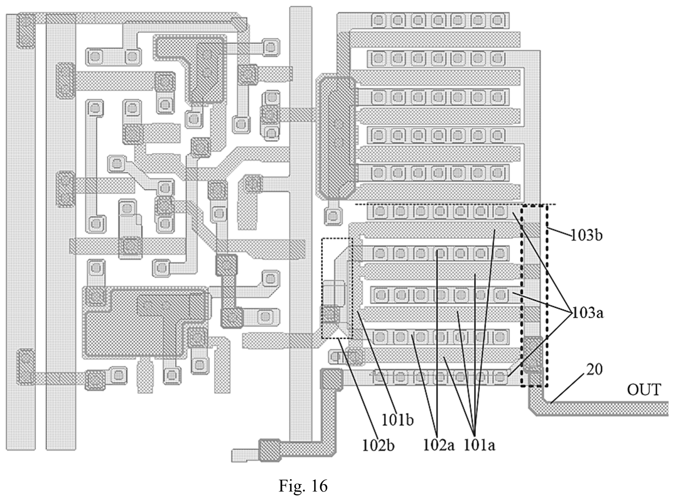

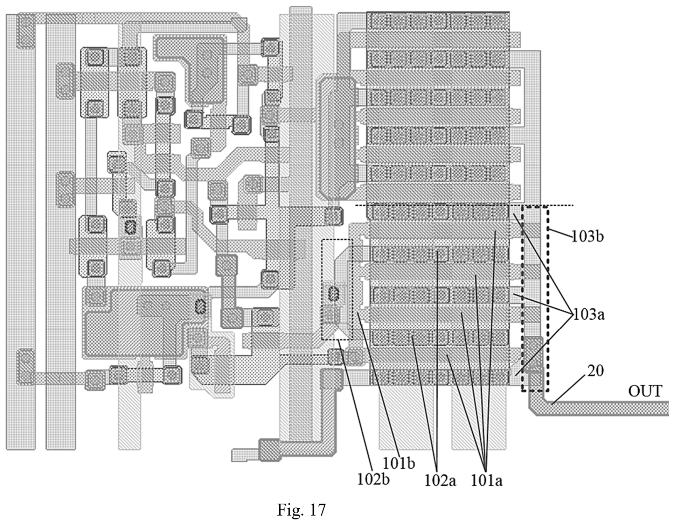

As shown in Figs. 15 to 17, in some embodiments of the present disclosure, the orthogonal projection of at least one gate electrode pattern 101a onto the base substrate at least partially overlaps with an orthogonal projection of the second electrode connection member 103b onto the base substrate.

For example, the orthogonal projection of each gate electrode pattern 101a onto the base substrate at least partially overlaps with the orthogonal projection of the second electrode connection member 103b onto the base substrate.

For example, the shift register unit further includes an output end connection member 20 coupled to the gate driving signal output end OUT and the second electrode 103 of the first output transistor, and an orthogonal projection of the output end connection member 20 onto the base substrate does not overlap with the orthogonal projection of the gate electrode pattern 101a onto the base substrate.

Based on the above, through increasing an overlapping area between the gate electrode 101 and the second electrode of the first output transistor, the capacitance of the first capacitor C_N7_out increases, so as to effectively reduce the step of the gate driving signal outputted by the shift register unit, improve the output stability of the gate driving signal, and prevent the occurrence of such display defects as Mura in a case that the display product is driven by the gate driving signal for display, thereby to provide the high display quality.

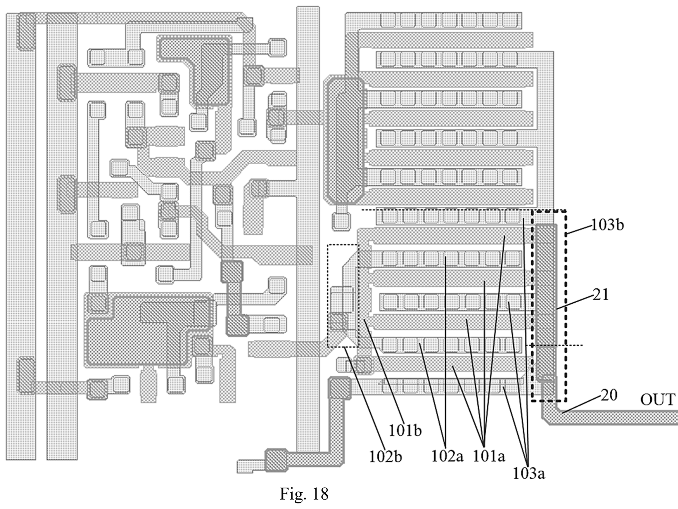

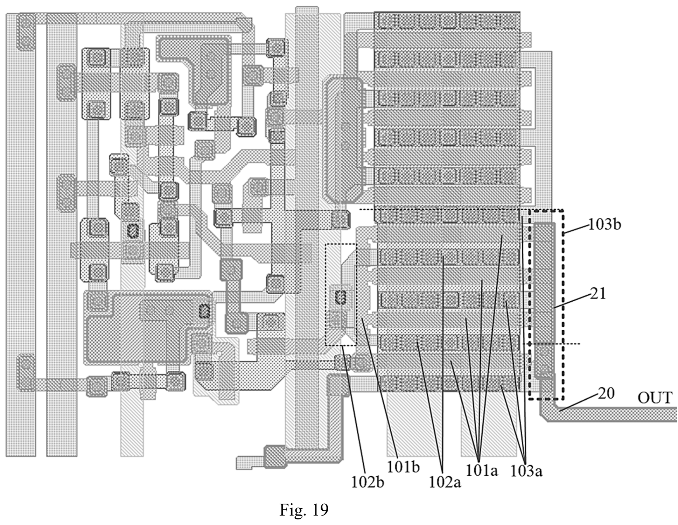

As shown in Figs. 18 and 19, in some embodiments of the present disclosure, the shift register unit further includes an output end extension member 21 coupled to the output end connection member 20, and an orthogonal projection of the output end extension member 21 onto the base substrate at least partially overlaps with the orthogonal projection of the gate electrode pattern 101a onto the base substrate.

For example, the output end extension member 21 and the output end connection member 20 form an integral structure.

For example, the orthogonal projection of the output end extension member 21 onto the base substrate at least partially overlaps with the orthogonal projection of the second electrode connection member 103b onto the base substrate.

Based on the above, through increasing the capacitance of the first capacitor C_N7_out, it is able to effectively reduce the step of the gate driving signal outputted by the shift register unit, improve the output stability of the gate driving signal, and prevent the occurrence of such display defects as Mura in a case that the display product is driven by the gate driving signal for display, thereby to provide the high display quality.

In some embodiments of the present disclosure, the display substrate includes a first gate metal layer gate1, a second gate metal layer gate2 and a first source/drain metal layer SD1 laminated one on another in a direction away from the base substrate, the gate electrode 101 of the first output transistor is arranged at a same layer, and made of a same material, as the first gate metal layer gate1, the first electrode 102 and the second electrode 103 of the first output transistor are arranged at a same layer, and made of a same material, as the first source/drain metal layer SD1, and the output end connection member 20 and the output end extension member 21 are arranged at a same layer, and made of a same material, as the second gate metal layer gate2.

As shown in Fig. 4, for example, the display substrate includes a buffer layer BF, an active layer poly, a first gate insulation layer GI1, a first gate metal layer gate1, a second gate insulation layer GI2, a second gate metal layer gate2, an interlayer insulation layer ILD, a first source/drain metal layer SD1, a first planarization layer PLN1, a second source/drain metal layer SD2, a second planarization layer PLN2, an anode layer ANO, a light-emitting functional layer EL, a cathode layer cath, a first inorganic encapsulation layer CVD1, an organic encapsulation layer IJP, and a second inorganic encapsulation layer CVD2 laminated one on another in a direction away from the base substrate 70. The display substrate further includes, but not limited to, a passivation layer PVX.

The gate electrode 101 of the first output transistor is arranged at a same layer, and made of a same material, as the first gate metal layer gate1, so that the gate electrode 101 of the first output transistor and the first gate metal layer gate1 are formed through a single patterning process. In this way, it is able to simplify a manufacture process of the display substrate, and reduce the manufacture cost of the display substrate.

The first electrode 102 and the second electrode 103 of the first output transistor are arranged at a same layer, and made of a same material, as the first source/drain metal layer SD1, so that the first electrode 102 and the second electrode 103 of the first output transistor and the first source/drain metal layer SD1 are formed through a single patterning process. In this way, it is able to simplify a manufacture process of the display substrate, and reduce the manufacture cost of the display substrate.

The output end connection member 20 and the output end extension member 21 are arranged at a same layer, and made of a same material, as the second gate metal layer gate2, so that the output end connection member 20, the output end extension member 21 and the second gate metal layer gate2 are formed through a single patterning process. In this way, it is able to simplify a manufacture process of the display substrate, and reduce the manufacture cost of the display substrate.

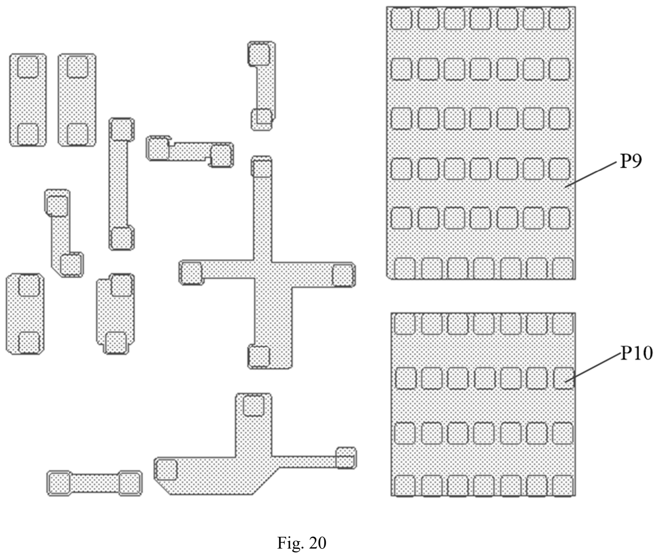

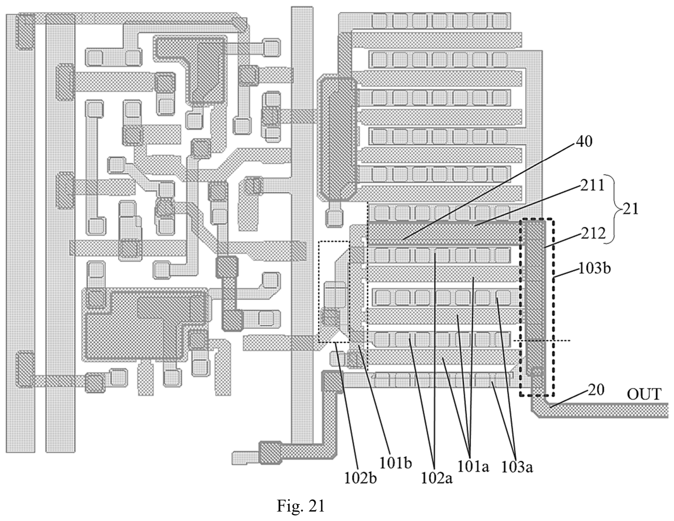

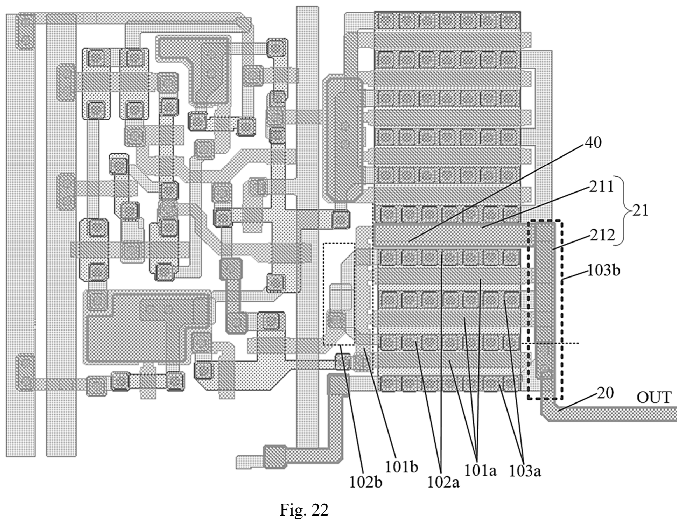

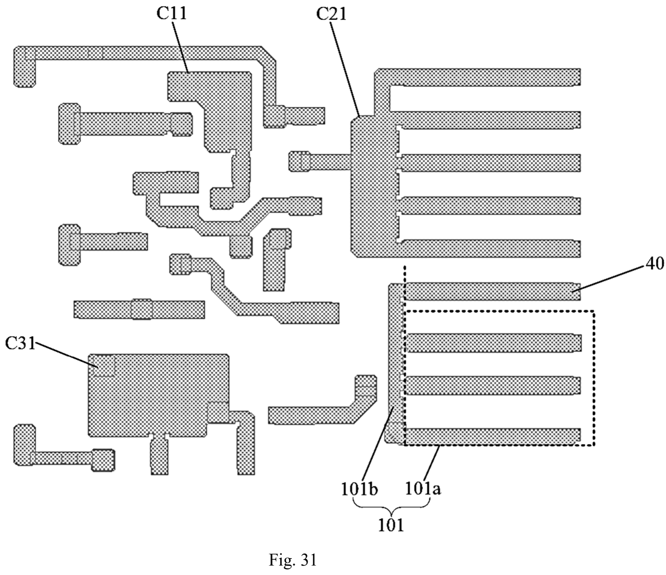

As shown in Figs. 20 to 22, 31 and 32, in some embodiments of the present disclosure, the first output transistor further includes a first output active layer P10, the shift register unit further includes a first compensation pattern 40 coupled to the gate electrode 101 of the first output transistor, an orthogonal projection of the first compensation pattern 40 onto the base substrate does not overlap with an orthogonal projection of the first output active layer P10 onto the base substrate, and the orthogonal projection of the first compensation pattern 40 onto the base substrate at least partially overlaps with the orthogonal projection of the output end extension member 21 onto the base substrate.

For example, the first output active layer P10 includes a channel portion and a conductor portion. An orthogonal projection of the channel portion onto the base substrate overlaps with the orthogonal projection of the gate electrode 101 onto the first output transistor. An orthogonal projection of the conductor portion onto the base substrate at least partially overlaps with the orthogonal projection of the first electrode 102 of the first output transistor onto the base substrate, and the orthogonal projection of the conductor portion onto the base substrate at least partially overlaps with the orthogonal projection of the second electrode 103 of the first output transistor onto the base substrate.

For example, the first compensation pattern 40 and the gate electrode 101 of the first output transistor form an integral structure.

For example, the first compensation pattern 40 and the gate electrode pattern 101a are arranged in the second direction.

For example, the orthogonal projection of the first compensation pattern 40 onto the base substrate and the orthogonal projection of the first output active layer P10 onto the base substrate in the second direction.

For example, the orthogonal projection of the first compensation pattern 40 onto the base substrate at least partially overlaps with the orthogonal projection of the second electrode connection member 103b onto the base substrate.

Based on the above, the orthogonal projection of the first compensation pattern 40 onto the base substrate at least partially overlaps with the orthogonal projection of the output end extension member 21 onto the base substrate, so as to increase the capacitance of the first capacitor C_N7_out, reduce the step of the gate driving signal outputted by the shift register unit, improve the output stability of the gate driving signal, and prevent the occurrence of such display defects as Mura in a case that the display product is driven by the gate driving signal for display, thereby to provide the high display quality.

As shown in Figs. 20 to 22, in some embodiments of the present disclosure, the output end extension member 21 includes a first extension portion 211 and a second extension portion 212 coupled to each other, the first extension portion 211 extends in the first direction, the second extension portion 212 extends in the second direction, an orthogonal projection of the first extension portion 211 onto the base substrate at least partially overlaps with the orthogonal projection of the first compensation pattern 40 onto the base substrate, an orthogonal projection of the second extension portion 212 onto the base substrate at least partially overlaps with the orthogonal projection of the second electrode connection member 103b onto the base substrate, and the first compensation pattern 40 and the gate electrode pattern 101a are arranged in the second direction.

For example, the first extension portion 211 and the second extension portion 212 form an integral structure.

For example, the orthogonal projection of the first compensation pattern 40 onto the base substrate at least partially overlaps with the orthogonal projection of the second electrode connection member 103b onto the base substrate.

Based on the above, through the appropriate layout, it is able to reduce a layout difficulty of the shift register unit while increasing the capacitance of the first capacitor C_N7_out.

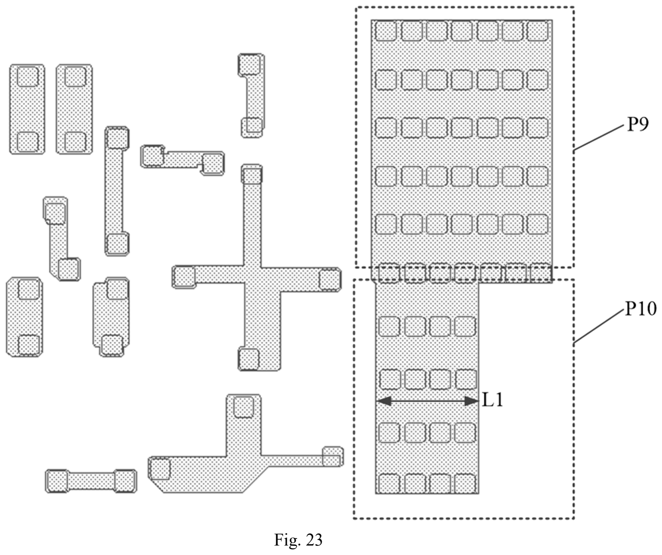

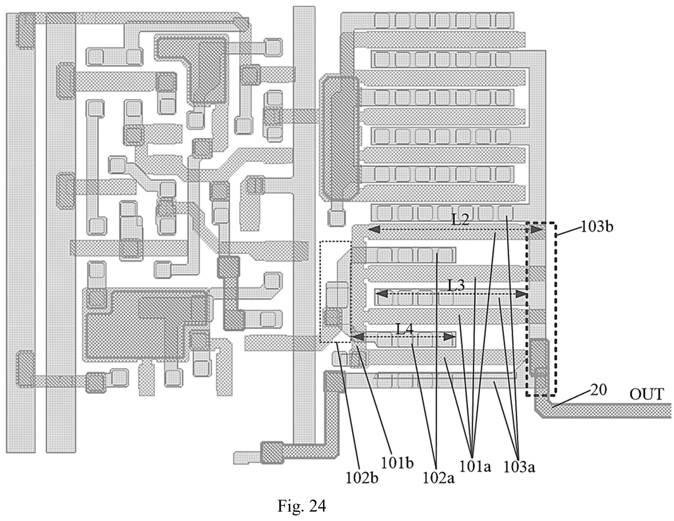

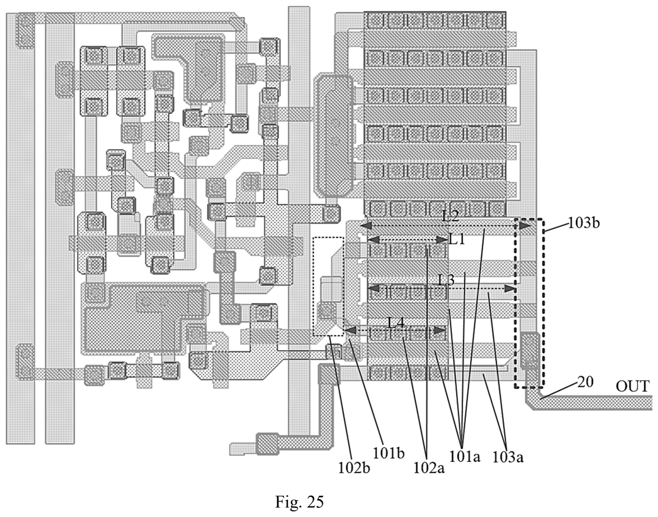

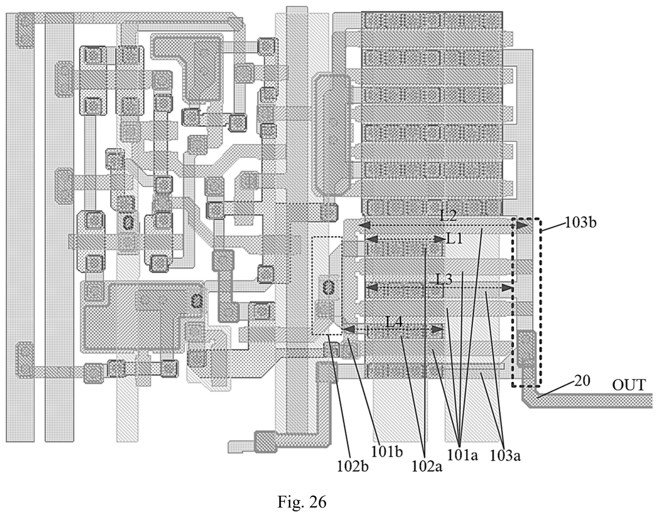

As shown in Figs. 23 to 26, in some embodiments of the present disclosure, the first output transistor further includes a first output active layer P10, the first output active layer P10 has a first length L1 in the first direction, the gate electrode pattern 101a has a second length L2 in the first direction, and the first length L1 is smaller than or equal to two thirds of the second length L2.

For example, the second electrode pattern 103a has a third length L3 in the first direction, and the first length L1 is smaller than or equal to two thirds of the third length L3.

For example, the first electrode pattern 102a has a fourth length L4 in the first direction, the fourth length L4 is smaller than the third length L3, and/or the fourth length L4 is smaller than the second length L2.

Based on the above, a width of the first output active layer P10 is reduced in the first direction, i.e., a length of a portion of each of the gate electrode pattern 101a and the second electrode pattern 103a not overlapping with the first output active layer P10 is increased in the first direction, so as to increase the capacitance of the first capacitor C_N7_out, reduce the step of the gate driving signal outputted by the shift register unit, improve the output stability of the gate driving signal, and prevent the occurrence of such display defects as Mura in a case that the display product is driven by the gate driving signal for display, thereby to provide the high display quality.

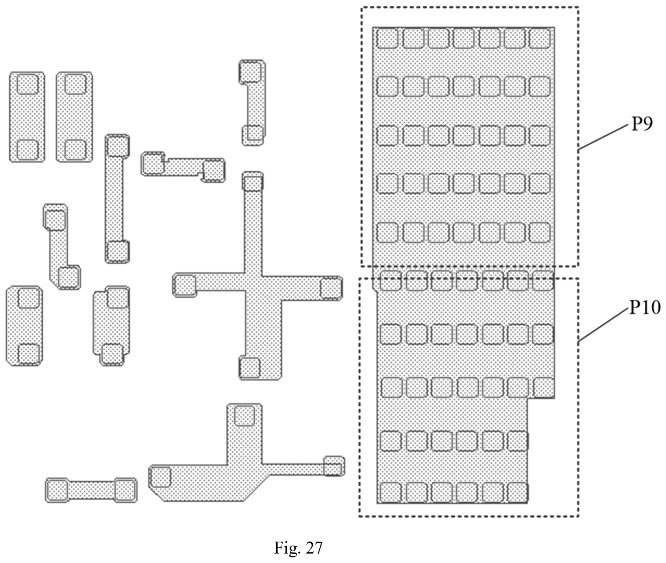

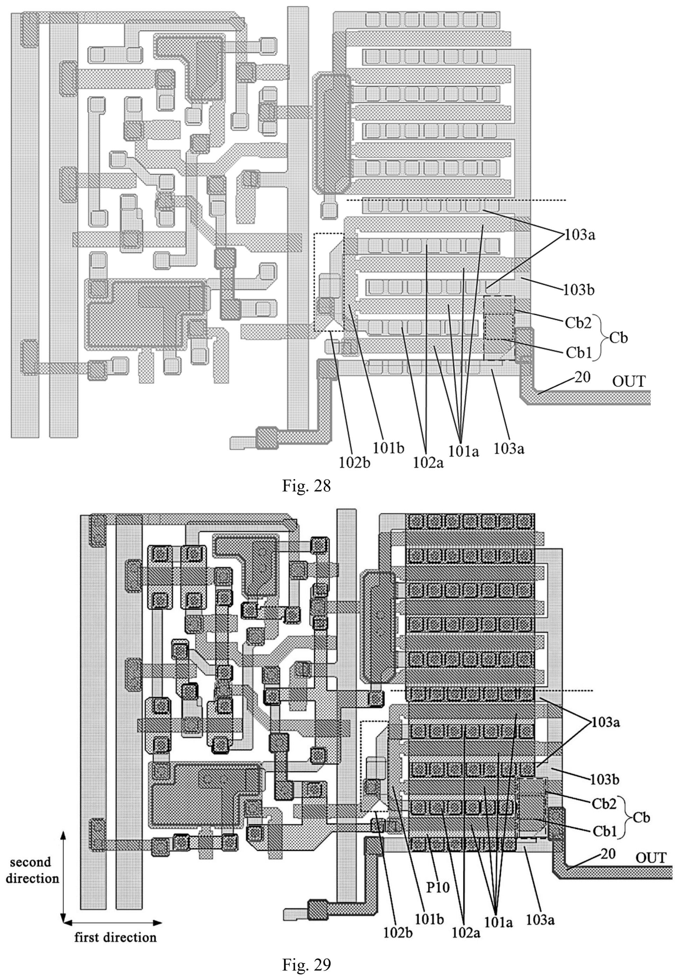

As shown in Figs. 27 to 30, in some embodiments of the present disclosure, the shift register unit further includes a compensation capacitor Cb, the compensation capacitor Cb includes a first compensation plate Cb1 and a second compensation plate Cb2, the first compensation plate Cb1 is coupled to the gate electrode 101 of the first output transistor, the second compensation plate Cb2 is coupled to the second electrode 103 of the first output transistor, and an orthogonal projection of the first compensation plate Cb1 onto the base substrate at least partially overlaps with an orthogonal projection of the second compensation plate Cb2 onto the base substrate.

In the display substrate provided in the embodiments of the present disclosure, through the compensation capacitor Cb, the capacitance of the first capacitor C_N7_out increases, so as to reduce the step of the gate driving signal outputted by the shift register unit, improve the output stability of the gate driving signal, and prevent the occurrence of such display defects as Mura in a case that the display product is driven by the gate driving signal for display, thereby to provide the high display quality.

As shown in Figs. 27 to 30, in some embodiments of the present disclosure, the first compensation plate Cb1 is coupled to two adjacent gate electrode patterns 101a, and the second compensation plate Cb2 is coupled to the second electrode connection member 103b and two adjacent second electrode patterns 103a.

For example, the orthogonal projection of the first compensation plate Cb1 onto the base substrate is arranged between the orthogonal projections of the two adjacent gate electrode patterns 101a onto the base substrate.

For example, the orthogonal projection of the second compensation plate Cb2 onto the base substrate is arranged between the orthogonal projections of the two adjacent second electrode patterns 103a onto the base substrate.

For example, the second electrode connection member 103b and the two adjacent second electrode patterns 103a surround the second compensation plate Cb2.

For example, the first compensation plate Cb1 and the gate electrode pattern 101a form an integral structure, and the second compensation plate Cb2, the second electrode connection member 103b and the second electrode pattern 103a form an integral structure.

Based on the above, through the appropriate layout, it is able to reduce the layout difficulty of the shift register unit while increasing the capacitance of the first capacitor C_N7_out.

As shown in Figs. 27 to 30, in some embodiments of the present disclosure, the first output transistor further includes a first output active layer P10. At least a portion of an orthogonal projection of the first output active layer P10 onto the base substrate and the orthogonal projection of the first compensation plate Cb1 onto the base substrate are arranged in the first direction, and at least a portion of the orthogonal projection of the first output active layer P10 onto the base substrate and at least a portion of the orthogonal projection of the first compensation plate Cb1 onto the base substrate are arranged in the second direction; and/or at least a portion of the orthogonal projection of the first output active layer P10 onto the base substrate and the orthogonal projection of the second compensation plate Cb2 onto the base substrate are arranged in the first direction, and at least a portion of the orthogonal projection of the first output active layer P10 onto the base substrate and at least a portion of the orthogonal projection of the second compensation plate Cb2 onto the base substrate are arranged in the second direction.

For example, the first output active layer P10 is of an L-like shape, and the orthogonal projection of the first output active layer P10 onto the base substrate surrounds at least a portion of the orthogonal projections of the first compensation plate Cb1 and/or the second compensation plate Cb2 onto the base substrate.

Based on the above, through the appropriate layout, it is able to reduce the layout difficulty of the shift register unit while increasing the capacitance of the first capacitor C_N7_out.

As shown in Figs. 1, and 5 to 14, in some embodiments of the present disclosure, the display substrate further includes a second level signal line VGH, the shift register unit further includes a second output transistor (e.g., the ninth transistor T9) and a second output control node (e.g., the fourth node N4), a gate electrode of the second output transistor is coupled to the second output control node, a first electrode of the second output transistor is coupled to the second level signal line VGH, and a second electrode of the second output transistor is coupled to the gate driving signal output end OUT.

For example, the first level signal line VGL is used to transmit a first level signal, the second level signal line VGH is used to transmit a second level signal, the first level signal includes a low level signal, the second level signal includes a high level signal, but the present disclosure is not limited thereto.

Fig. 5 further shows a first active layer P1, a second active layer P2, a third active layer P3, a fourth active layer P4, a fifth active layer P5, a sixth active layer P6, a seventh active layer P7, an eighth active layer P8, a ninth active layer P9, an eleventh active layer P11, a twelfth active layer P12, a thirteenth active layer P13, a fourteenth active layer P14, a fifteenth active layer P15, and a sixteenth active layer P16.

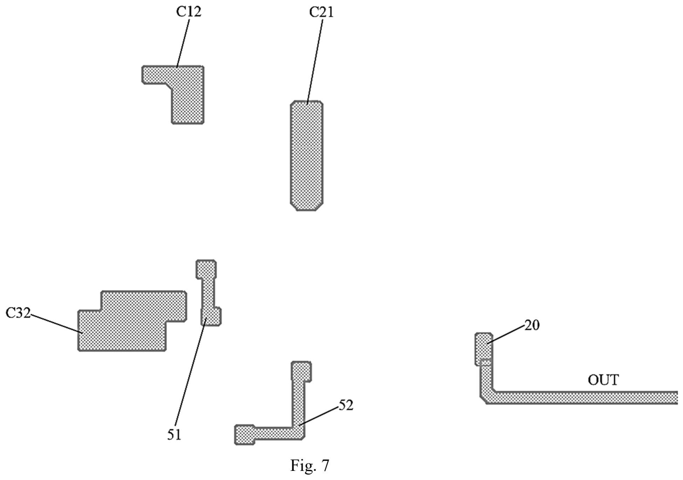

Fig. 7 further shows a first conductive connection member 51 and a second conductive connection member 52.

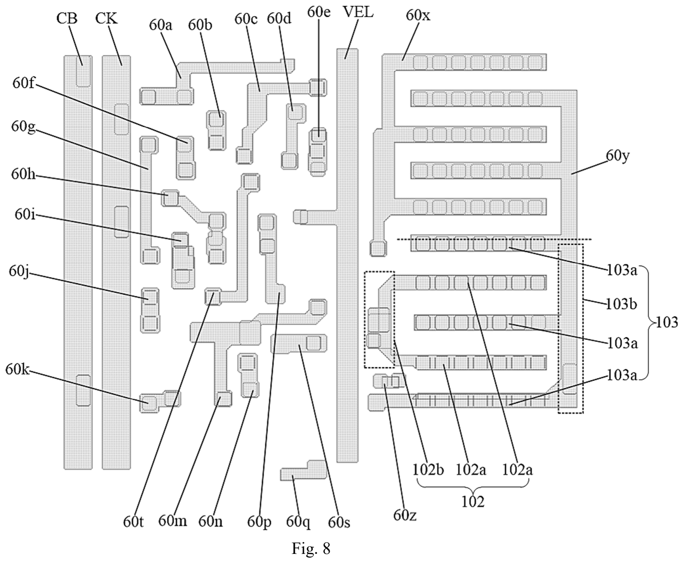

As shown in Fig. 8, a first conductive pattern 60a is coupled to the first transistor T1, the fourteenth transistor T14 and the frame start signal line. A second conductive pattern 60b is coupled to the gate electrode of the second transistor T2, the first transistor T1 and the first clock signal line CK. A third conductive pattern 60c serves as the third node N3. A fourth conductive pattern 60d is coupled to the gate electrode of the seventh transistor T7, the sixth transistor T6 and the second clock signal line CB. A fifth conductive pattern 60e serves the fourth node N4. A sixth conductive pattern 60f is coupled to the gate electrode of the second transistor T2 and the first transistor T1. A seventh conductive pattern 60g serves the eighth node N8. An eighth conductive pattern 60h serves as the second node N2. A ninth conductive pattern 60i is coupled to the first level signal line VGL, the gate electrode of the eleventh transistor T11 and the second transistor T2. A tenth conductive pattern 60j is coupled to the third capacitor unit C3 and the fifteenth transistor T15. An eleventh conductive pattern 60k is coupled to the fourth transistor T4 and the second clock signal line CB. A twelfth conductive pattern 60m serves as the fifth node N5, and it is further coupled to a twenty-first conductive pattern 60w. A thirteenth conductive pattern 60n is coupled to the third capacitor unit C3 and the sixteenth transistor T16. A fourteenth conductive pattern 60p is coupled to the gate electrode of the second transistor T2, the gate electrode of the eighth transistor T8, the thirteenth transistor T13 and the first conductive connection member 51. A fifteenth conductive pattern 60q is coupled to the second conductive connection member 52, and it is further coupled to the second electrode pattern 103a. A sixteenth conductive pattern 60s is coupled to the twelfth transistor T12 and the first conductive connection member 51. A seventeenth conductive pattern 60t is coupled to the gate electrode of the sixth transistor T6 and the eleventh transistor T11. An eighteenth transistor 60x serves as the first electrode of the ninth transistor T9, and it is coupled to the eighth transistor T8, the fifth transistor T5 and the thirteenth transistor T13. A nineteenth conductive pattern 60y serves as the second electrode of the ninth transistor T9, and it is coupled to the driving signal output end OUT. A twentieth conductive pattern 60z serves as the seventh node N7.

The present disclosure further provides in some embodiments a display device, which includes the above-mentioned display substrate.

It should be appreciated that, the display device may be any product or member having a display function, e.g., television, display, digital photo frame, mobile phone or tablet computer. The display device may further include a flexible circuit board, a printed circuit board and a back plate.

In the embodiments of the present disclosure, the first capacitor is formed between the first output control node and the gate driving signal output end, the second capacitor is formed between the first output control node and the first level signal line, and the capacitance of the first capacitor is greater than the capacitance of the second capacitor, so that the first capacitor having a larger capacitance is formed between the first output control node and the gate driving signal output end, and the second capacitor having a smaller capacitance is formed between the first output control node and the first level signal line. As a result, it is able to effectively reduce the step of the gate driving signal outputted by the shift register unit, improve the output stability of the gate driving signal, and prevent the occurrence of such display defects as mura in a case that a display product is driven by the gate driving signal for display, thereby to provide high display quality.

In a case that the display device includes the above-mentioned display substrate, it also has the above-mentioned beneficial effects, which will not be particularly defined herein.

As shown in Figs. 1, and 5 to 30, the present disclosure further provides in some embodiments a method for driving the above-mentioned display substrate. The display substrate includes a base substrate, and a first level signal line VGL and a shift register unit on the base substrate. The shift register unit includes a first output transistor, a gate driving signal output end OUT and a first output control node. A gate electrode 101 of the first output is coupled to the first output control node, a first electrode 102 of the first output transistor is coupled to the first level signal line, and a second electrode 103 of the first output transistor is coupled to the gate driving signal output end OUT. A first capacitor is formed between the first output control node and the gate driving signal output end OUT, a second capacitor is formed between the first output control node and the first level signal line VGL, and the first capacitor has a capacitance greater than or equal to the second capacitor. The driving method includes controlling, by the first output control node, the first output transistor to be turned on or off.

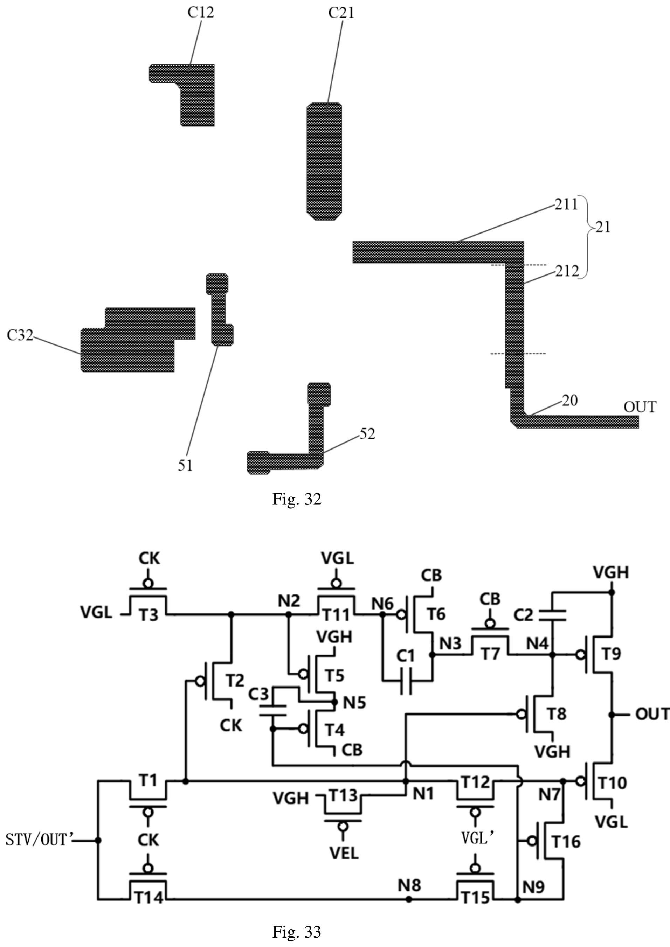

As shown in Fig. 33, in some embodiments of the present disclosure, the display substrate includes a frame start signal line STV, a first clock signal line CK, a third level signal line VGL', and a plurality of cascaded shift register units. Each shift register unit further includes a first input transistor (e.g., the first transistor T1), a second input transistor (e.g., the fourteenth transistor T14), a first transmission transistor (e.g., the twelfth transistor T12), a second transmission transistor (e.g., the fifteenth transistor T15) and a control transistor (e.g., the sixteenth transistor T16).

A gate electrode of the first input transistor is coupled to a corresponding first clock signal line CK, a second electrode of the first input transistor is coupled to a first electrode of the first transmission transistor, a gate electrode of the first transmission transistor is coupled to the third level signal line VGL', a second electrode of the first transmission transistor is coupled to the first output control node, a gate electrode of the second input transistor is coupled to a corresponding first clock signal line CK, a second electrode of the second input transistor is coupled to a first electrode of the second transmission transistor, a gate electrode of the second transmission transistor is coupled to the third level signal line VGL', a second electrode of the second transmission transistor is coupled to a gate electrode and a second electrode of the control transistor, and a first electrode of the control transistor is coupled to the first output control node.

In a first shift register unit, the first electrode of the first input transistor is coupled to the frame start signal line STV, and in an n^{th} shift register unit, the first electrode of the first input transistor is coupled to a gate driving signal output end OUT' of an (n-1)^{th} shift register unit, where n is an integer greater than or equal to 2.

A low level of a first clock signal transmitted by the first clock signal line CK is smaller than a level of a first level signal transmitted by the first level signal line VGL; and/or the low level of the first clock signal transmitted by the first clock signal line CK is smaller than a level of a frame start signal; and/or a level of a third level signal transmitted by the third level signal line VGL' is smaller than the level of the first level signal transmitted by the first level signal line VGL.

More specifically, in a case that the frame start signal transmitted by the frame start signal line STV has a level of -6V and the first clock signal has a level of -6V, a voltage across the first output control node is about -4V due to a loss of a threshold voltage of the first input transistor, so the first output transistor may be turned on slowly. In a case that the frame start signal transmitted by the frame start signal line STV has a level of -6V and the first clock signal has a low level of -10V, the voltage across the first output control node is far smaller than that in the previous situation even with the loss, so it is able to rapidly turn on the first output transistor.

Based on the above, the low level of the first clock signal transmitted by the first clock signal line CK is smaller than the level of the first level signal transmitted by the first level signal line VGL, and/or the low level of the first clock signal transmitted by the first clock signal line CK is smaller than the level of the frame start signal, so that in each shift register unit, a gate-to-source voltage of each of the first input transistor and the second input transistor is relatively large. In this way, it is able to fully turn on the two transistors.

Based on the above, the level of the third level signal transmitted by the third level signal line VGL' is smaller than the level of the first level signal transmitted by the first level signal line VGL, so that the gate electrode of each of the first transmission transistor and the second transmission transistor receives a lower on-state level signal. In this way, it is able to ensure that the first transmission transistor and the second transmission transistor are fully turned on.

In a case that the display substrate is driven using the above-mentioned driving method, it is able to ensure the potential at the first output control node, thereby to control the first output transistor to be turned on in a better manner.

It should be appreciated that, in the case that a signal line extends along a direction X, it means that a primary portion of the signal line, e.g., a line, a segment or a strip-like body, extends along the direction X, and an extension length of the primary portion is greater than an extension length of a secondary portion of the signal line, which is coupled to the primary portion, in the other direction.

It should be further appreciated that, the expression "at a same layer" refers to that the film layers are arranged on a same structural layer. Alternatively, for example, the film layers on a same layer may be layer structures formed through forming thin layers for forming specific patterns through a single-film-forming process and then patterning the film layers with a same mask through a single patterning process. Depending on different specific patterns, a single patterning process may include multiple exposing, development or etching processes, and the specific patterns in the layer structure may be continuous or discontinuous. These specific patterns may also be arranged at different levels or have different thicknesses.

In the embodiments of the present disclosure, the order of the steps is not limited to the serial numbers thereof. For a person skilled in the art, any change in the order of the steps shall also fall within the scope of the present disclosure if without any creative effort.

It should be further appreciated that, the above embodiments have been described in a progressive manner, and the same or similar contents in the embodiments have not been repeated, i.e., each embodiment has merely focused on the difference from the others. Especially, the method embodiments are substantially similar to the product embodiments, and thus have been described in a simple manner.

Unless otherwise defined, any technical or scientific term used herein shall have the common meaning understood by a person of ordinary skills. Such words as "first" and "second" used in the specification and claims are merely used to differentiate different components rather than to represent any order, number or importance. Similarly, such words as "one" or "one of" are merely used to represent the existence of at least one member, rather than to limit the number thereof. Such words as "include" or "including" intends to indicate that an element or object before the word contains an element or object or equivalents thereof listed after the word, without excluding any other element or object. Such words as "connect/connected to" or "couple/coupled to" may include electrical connection, direct or indirect, rather than to be limited to physical or mechanical connection. Such words as "on", "under", "left" and "right" are merely used to represent relative position relationship, and when an absolute position of the object is changed, the relative position relationship will be changed too.

It should be appreciated that, in the case that such an element as layer, film, region or substrate is arranged "on" or "under" another element, it may be directly arranged "on" or "under" the other element, or an intermediate element may be arranged therebetween.

In the above description, the features, structures, materials or characteristics may be combined in any embodiment or embodiments in an appropriate manner.

The above embodiments are merely for illustrative purposes, but shall not be construed as limiting the scope of the present disclosure. Any person skilled in the art may make modifications and substitutions without departing from the spirit of the present disclosure, and these modifications and substitutions shall also fall within the scope of the present disclosure. Hence, the scope of the present disclosure shall be subject to the scope defined by the appended claims.

## Claims

1. A display substrate, comprising a base substrate, and a first level signal line and a shift register unit on the base substrate, wherein the shift register unit comprises a first output transistor, a gate driving signal output end and a first output control node;
a gate electrode of the first output transistor is coupled to the first output control node, a first electrode of the first output transistor is coupled to the first level signal line, and a second electrode of the first output transistor is coupled to the gate driving signal output end; and
a first capacitor is formed between the first output control node and the gate driving signal output end, a second capacitor is formed between the first output control node and the first level signal line, and the first capacitor has a capacitance greater than or equal to the second capacitor.

2. The display substrate according to claim 1, wherein the gate electrode of the first output transistor comprises at least one gate electrode pattern extending in a first direction, the first electrode of the first output transistor comprises at least one first electrode pattern extending in the first direction, and the second electrode of the first output transistor comprises at least one second electrode pattern extending in the first direction;
the first electrode pattern and the second electrode pattern are arranged in a second direction intersecting the first direction, and an orthogonal projection of the gate electrode pattern onto the base substrate is arranged between an orthogonal projection of an adjacent first electrode pattern onto the base substrate and an orthogonal projection of the second electrode pattern onto the base substrate; and
the orthogonal projection of at least one of the gate electrode patterns onto the base substrate is spaced apart from the orthogonal projection of the adjacent first electrode pattern onto the base substrate by a first distance, the orthogonal projection of at least one of the gate electrode patterns onto the base substrate is spaced apart from the orthogonal projection of an adjacent second electrode pattern onto the base substrate by a second distance, and the first distance is greater than the second distance.

3. The display substrate according to claim 2, wherein the gate electrode of the first output transistor comprises a gate electrode connection member and at least two gate electrode patterns coupled to the gate electrode connection member, the first electrode of the first output transistor comprises a first electrode connection member and at least two first electrode patterns coupled to the first electrode connection member, the second electrode of the first output transistor comprises a second electrode connection member and at least two second electrode patterns coupled to the second electrode connection member, the first electrode patterns and the second electrode patterns are arranged alternately in the second direction, the first electrode connection member is coupled to the first level signal line, and the second electrode connection member is coupled to the gate driving signal output end.

4. The display substrate according to claim 2 or 3, wherein the orthogonal projection of each gate electrode pattern onto the base substrate is spaced apart from the orthogonal projection of the adjacent first electrode pattern onto the base substrate by the first distance, and the orthogonal projection of each gate electrode pattern onto the base substrate is spaced apart from the orthogonal projection of the adjacent second electrode pattern onto the base substrate by the second distance.

5. The display substrate according to claim 3, wherein the orthogonal projection of at least one gate electrode pattern onto the base substrate at least partially overlaps with an orthogonal projection of the second electrode connection member onto the base substrate.

6. The display substrate according to claim 5, wherein the shift register unit further comprises an output end connection member coupled to the gate driving signal output end and the second electrode of the first output transistor, and an orthogonal projection of the output end connection member onto the base substrate does not overlap with the orthogonal projection of the gate electrode pattern onto the base substrate.

7. The display substrate according to claim 6, wherein the shift register unit further comprises an output end extension member coupled to the output end connection member, and an orthogonal projection of the output end extension member onto the base substrate at least partially overlaps with the orthogonal projection of the gate electrode pattern onto the base substrate.

8. The display substrate according to claim 7, wherein the orthogonal projection of the output end extension member onto the base substrate at least partially overlaps with the orthogonal projection of the second electrode connection member onto the base substrate.

9. The display substrate according to claim 7 or 8, wherein the display substrate comprises a first gate metal layer, a second gate metal layer and a first source/drain metal layer laminated one on another in a direction away from the base substrate, the gate electrode of the first output transistor is arranged at a same layer, and made of a same material, as the first gate metal layer, the first electrode and the second electrode of the first output transistor are arranged at a same layer, and made of a same material, as the first source/drain metal layer, and the output end connection member and the output end extension member are arranged at a same layer, and made of a same material, as the second gate metal layer.

10. The display substrate according to claim 7 or 8, wherein the first output transistor further comprises a first output active layer, the shift register unit further comprises a first compensation pattern coupled to the gate electrode of the first output transistor, an orthogonal projection of the first compensation pattern onto the base substrate does not overlap with an orthogonal projection of the first output active layer onto the base substrate, and the orthogonal projection of the first compensation pattern onto the base substrate at least partially overlaps with the orthogonal projection of the output end extension member onto the base substrate.

11. The display substrate according to claim 10, wherein the output end extension member comprises a first extension portion and a second extension portion coupled to each other, the first extension portion extends in the first direction, the second extension portion extends in the second direction, an orthogonal projection of the first extension portion onto the base substrate at least partially overlaps with the orthogonal projection of the first compensation pattern onto the base substrate, an orthogonal projection of the second extension portion onto the base substrate at least partially overlaps with the orthogonal projection of the second electrode connection member onto the base substrate, and the first compensation pattern and the gate electrode pattern are arranged in the second direction.

12. The display substrate according to claim 5, wherein the first output transistor further comprises a first output active layer, the first output active layer has a first length in the first direction, the gate electrode pattern has a second length in the first direction, and the first length is smaller than or equal to two thirds of the second length.

13. The display substrate according to claim 12, wherein the second electrode pattern has a third length in the first direction, and the first length is smaller than or equal to two thirds of the third length.

14. The display substrate according to claim 12 or 13, wherein the first electrode pattern has a fourth length in the first direction, the fourth length is smaller than the third length, and/or the fourth length is smaller than the second length.

15. The display substrate according to claim 3, wherein the shift register unit further comprises a compensation capacitor, the compensation capacitor comprises a first compensation plate and a second compensation plate, the first compensation plate is coupled to the gate electrode of the first output transistor, the second compensation plate is coupled to the second electrode of the first output transistor, and an orthogonal projection of the first compensation plate onto the base substrate at least partially overlaps with an orthogonal projection of the second compensation plate onto the base substrate.

16. The display substrate according to claim 15, wherein the first compensation plate is coupled to two adjacent gate electrode patterns, and the second compensation plate is coupled to the second electrode connection member and two adjacent second electrode patterns.

17. The display substrate according to claim 16, wherein the first compensation plate and the gate electrode pattern form an integral structure, and the second compensation plate, the second electrode connection member and the second electrode pattern form an integral structure.

18. The display substrate according to any one of claims 15 to 17, wherein the first output transistor further comprises a first output active layer;
at least a portion of an orthogonal projection of the first output active layer onto the base substrate and the orthogonal projection of the first compensation plate onto the base substrate are arranged in the first direction, and at least a portion of the orthogonal projection of the first output active layer onto the base substrate and at least a portion of the orthogonal projection of the first compensation plate onto the base substrate are arranged in the second direction; and/or
at least a portion of the orthogonal projection of the first output active layer onto the base substrate and the orthogonal projection of the second compensation plate onto the base substrate are arranged in the first direction, and at least a portion of the orthogonal projection of the first output active layer onto the base substrate and at least a portion of the orthogonal projection of the second compensation plate onto the base substrate are arranged in the second direction.

19. The display substrate according to claim 1, further comprising a second level signal line, wherein the shift register unit further comprises a second output transistor and a second output control node, a gate electrode of the second output transistor is coupled to the second output control node, a first electrode of the second output transistor is coupled to the second level signal line, and a second electrode of the second output transistor is coupled to the gate driving signal output end.

20. A display device, comprising the display substrate according to any one of claims 1 to 19.

21. A driving method for the display substrate according to any one of claims 1 to 19, wherein the display substrate comprises a base substrate, and a first level signal line and a shift register unit on the base substrate, wherein the shift register unit comprises a first output transistor, a gate driving signal output end and a first output control node; a gate electrode of the first output transistor is coupled to the first output control node, a first electrode of the first output transistor is coupled to the first level signal line, and a second electrode of the first output transistor is coupled to the gate driving signal output end; and a first capacitor is formed between the first output control node and the gate driving signal output end, a second capacitor is formed between the first output control node and the first level signal line, and the first capacitor has a capacitance greater than or equal to the second capacitor,
wherein the driving method comprises controlling, by the first output control node, the first output transistor to be turned on or off.

22. The driving method according to claim 21, wherein the display substrate comprises a frame start signal line, a first clock signal line, a third level signal line, and a plurality of cascaded shift register units, each shift register unit further comprises a first input transistor, a second input transistor, a first transmission transistor, a second transmission transistor and a control transistor;
a gate electrode of the first input transistor is coupled to a corresponding first clock signal line, a second electrode of the first input transistor is coupled to a first electrode of the first transmission transistor, a gate electrode of the first transmission transistor is coupled to the third level signal line, a second electrode of the first transmission transistor is coupled to the first output control node, a gate electrode of the second input transistor is coupled to a corresponding first clock signal line, a second electrode of the second input transistor is coupled to a first electrode of the second transmission transistor, a gate electrode of the second transmission transistor is coupled to the third level signal line, a second electrode of the second transmission transistor is coupled to a gate electrode and a second electrode of the control transistor, and a first electrode of the control transistor is coupled to the first output control node;
in a first shift register unit, the first electrode of the first input transistor is coupled to the frame start signal line, and in an n^{th} shift register unit, the first electrode of the first input transistor is coupled to a gate driving signal output end of an (n-1)^{th} shift register unit, where n is an integer greater than or equal to 2;
a low level of a first clock signal transmitted by the first clock signal line is smaller than a level of a first level signal transmitted by the first level signal line; and/or
the low level of the first clock signal transmitted by the first clock signal line is smaller than a level of a frame start signal; and/or
a level of a third level signal transmitted by the third level signal line is smaller than the level of the first level signal transmitted by the first level signal line.
